# EUROPEAN PATENT APPLICATION

(11) **EP 4 704 291 A1**
(43) Date of publication of application: **04.03.2026**
(21) Application number: 24306415.1
(22) Date of filing: 30.08.2024
(51) Int. Cl.: H02J 7/00, B60L 3/04

(54) **CONTROL DEVICE FOR A BATTERY CONNECTION UNIT, A BATTERY CONNECTION UNIT, AND A METHOD FOR THE CONTROL DEVICE**

(71) Applicant: NXP USA, Inc., Austin TX 78735 (US)
(72) Inventor: Huot-Marchand, Alexis Nathanael, 31023 Toulouse Cedex 1 (FR); Pennisi, Orazio, 5656 AG Eindhoven (NL); Lounis, Nesrine Myriem, 31023 Toulouse Cedex 1 (FR); Vedelago, Juliette Angèle, 31023 Toulouse Cedex 1 (FR)
(74) Representative: Schmütz, Christian Klaus Johannes

(57) **Abstract**

The present disclosure relates to a control device for a battery connection unit, the control device comprising an integrated circuit, IC, and a first reference impedance, wherein the IC comprises a trigger output for coupling to a pyro switch, wherein the IC is configured to generate at the trigger output a trigger signal for triggering the pyro switch, wherein the IC comprises a reference input for receiving a reference signal, wherein the first reference impedance is coupled to the reference input to generate the reference signal at the reference input depending on the first reference impedance, wherein the IC comprises a driver output for coupling to a reservoir capacitor, and wherein the IC is configured to generate a driver signal at the driver output for charging the reservoir capacitor according to the reference signal. The present disclosure also relates to a battery connection unit including the control device and to a method for the control device.

## Description

### TECHNICAL FIELD

The present disclosure relates to a control device for a battery connection unit, to a battery connection unit including the control device, and a method for the control device.

### BACKGROUND

Battery powered electrical systems are increasingly being used in automotive applications and other areas of technology. A battery powered electrical system may include an electrical battery as the energy source, an electrical device, and other components located between the battery and the electrical device. The other components can be used to transfer electrical energy from the battery to the electrical device. Other functions may also be provided by the other components. The electrical device may also be referred to as an electrical load. An electrical load may be, for example, an electrical drive for a motor vehicle, an electrical control unit, an airbag system for a motor vehicle, or another electrical sub-device.

One of the components arranged between the battery and the electrical device may be a battery connection unit. The battery connection unit may be a device. The battery connection unit may be integrated into an electrical string, referred to as a coupling string, between the battery and at least one electrical device.

The battery powered electrical system may further include a pyro switch. In an example, the pyro switch may be configured as a pyro fuse. The pyro switch can be used to interrupt an electrical connection. The pyro switch may contribute to the safety of the electrical system and/or the reliable operation of the electrical system. For example, if a malfunction such as excessive current, fire or other predefined critical event is detected, the pyro switch may be used to quickly disconnect the electrical connection between the electrical battery and the at least one electrical device. The pyro switch can be configured to be triggered by a trigger signal. The trigger signal can serve two purposes, firstly to trigger the pyro switch and secondly to provide the pyro switch with electrical energy for triggering. Supplying the pyro switch with electrical energy via the trigger signal offers the advantage that the pyro switch can also interrupt the electrical connection if, for example, the power supply via the electrical battery no longer provided due to the malfunction.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Aspects of the disclosure are defined in the accompanying claims.

In accordance with a first aspect of the present disclosure, a control device for a battery connection unit is provided. The control device comprising an integrated circuit, IC, and a first reference impedance, wherein the IC comprises a trigger output for coupling to a pyro switch, wherein the IC is configured to generate at the trigger output a trigger signal for triggering the pyro switch, wherein the IC comprises a reference input for receiving a reference signal, wherein the first reference impedance is coupled to the reference input to generate the reference signal at the reference input depending on the first reference impedance, wherein the IC comprises a driver output for coupling to a reservoir capacitor, and wherein the IC is configured to generate a driver signal at the driver output for charging the reservoir capacitor according to the reference signal.

In one or more embodiment, the IC is configured to be supplied with capacitor energy from the reservoir capacitor via the driver output, and wherein the IC is configured to be powered by the capacitor energy to generate the trigger signal.

In one or more embodiment, the IC is configured to detect a state of charge of the reservoir capacitor based on the driver signal and/or the reference signal, and wherein the IC is configured to be ready to generate the trigger signal at the trigger output as soon as the charge state of the reservoir capacitor reached at least a predefined reference charge state.

In one or more embodiment, the control device comprises a first battery terminal and a second battery terminal, wherein the IC is coupled to the first and second battery terminals, wherein the control device comprises a first interface terminal, wherein the control device is configured to receive a predefined first base voltage at the first interface terminal, and wherein the first reference impedance is coupled between the first interface terminal and the reference input of the IC.

In one or more embodiment, the IC is configured to generate a predefined voltage as a reference voltage of the reference signal at the reference input of the IC.

In one or more embodiment, the IC is configured to control a drive current of the drive signal according to a reference current of the reference signal.

In one or more embodiment, the IC is configured to control the drive current such that the drive current is proportional to the reference current, in particular in a predetermined ratio with a permissible deviation of less than 15%.

In one or more embodiment, the control device comprises a feedback loop coupled between the driver output of the IC and the reference input of the IC, and wherein a second reference impedance is integrated in the feedback loop.

In one or more embodiment, a diode is integrated into the feedback line, and wherein a forward direction of the diode in the feedback loop is directed from the driver output to the reference input.

In one or more embodiment, the IC comprises a first circuit string extending from the reference input of the IC to a second supply voltage terminal (ground) of the IC, and wherein a voltage regulation unit is integrated into the first circuit string, wherein the voltage regulation unit is configured to limit a voltage at the reference input of the IC to the second reference voltage.

In one or more embodiment, the IC comprises a second circuit string extending from a first supply voltage terminal of the IC to the second supply voltage terminal, wherein the IC comprises a first current mirror circuit comprising two transistors referred to as a first sensor transistor and a first mirror transistor, wherein the first sensor transistor is integrated into the first circuit string, wherein the first mirror transistor is integrated into the second circuit string, wherein the first mirror transistor is coupled to the first sensor transistor such that the first mirror transistor causes an intermediate string current in the second circuit string which is in a predefined first ratio to the reference current, wherein the IC comprises a third circuit string extending from the first supply voltage terminal to the driver output, wherein the IC comprises a second current mirror circuit comprising two transistors referred to as the second sensor transistor and the second mirror transistor, wherein the second sensor transistor is integrated into the second circuit string, wherein the second mirror transistor is integrated into the third circuit string, and wherein the second mirror transistor is coupled to the second sensor transistor such that the second mirror transistor causes the drive current in the third circuit string to be in a predefined second ratio to the intermediate string current.

In accordance with a second aspect of the present disclosure, a batter connection unit is provided. The battery connection unit comprising a control device according to the first aspect of the present disclosure (and/or according to any of the preceding embodiments), and a reservoir capacitor coupled to the driver output.

In one or more embodiment, the battery connection unit further comprises: a battery input terminal, a battery output terminal, a pyro switch, wherein a connection string extends from the battery input terminal to the battery output terminal, wherein the pyro-switch is integrated into the connection string, wherein the pyro-switch is coupled to the control device such that the reservoir capacitor provides electrical energy to the pyro-switch for triggering, wherein the IC is coupled to the pyro switch, and wherein the IC is configured to be ready to generate a triggering signal at the triggering output for triggering the pyro switch once the state of charge of the reservoir capacitor has reached at least a predefined reference state of charge.

In one or more embodiment, the battery connection unit comprises a current sensor for measuring a battery current in the connection string, wherein the current sensor is coupled to the IC, wherein the IC is configured to generate the trigger signal for triggering the pyro switch in response that the battery current reaches or exceeds a predefined threshold current value.

According to a third aspect of the present disclosure, a method for the control device is provided, where in the control device comprising an integrated circuit, IC, and a first reference impedance, the IC comprising a trigger output for coupling to a pyro-switch, the IC comprising a reference input, the first reference impedance being coupled to the reference input, the IC comprising a driver output, the IC comprising a driver output for coupling to a reservoir capacitor, the IC is configured to generate a trigger signal at the trigger output for triggering the pyro switch via energy of the reservoir capacitor, wherein the method comprising the following steps: (a) generating a reference signal at the reference input via and depending on the first reference impedance, (b) receiving a reference signal at a reference input of the IC, and (c) generating a driver signal depending on the reference signal via the IC at the driver output for charging the reservoir capacitor.

### DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:
Figure 1 schematically shows a simplified block diagram of an example of the control device and the battery connection unit.
Figure 2 schematically shows a simplified block diagram of another example of the control device and the battery connection unit.
Figure 3 shows an example of a simplified charge state curve for a reservoir capacitor.
Figure 4 shows an example of a simplified curve of a driver current.
Figure 5 shows an example of a simplified curve of a capacitor voltage.
Figure 6 shows another example of a simplified curve of a driver current.
Figure 7 shows an example of a simplified curve of the power transferred to the reservoir capacitor.
Figure 8 shows a simplified flow chart of the method.

### DESCRIPTION OF EMBODIMENTS

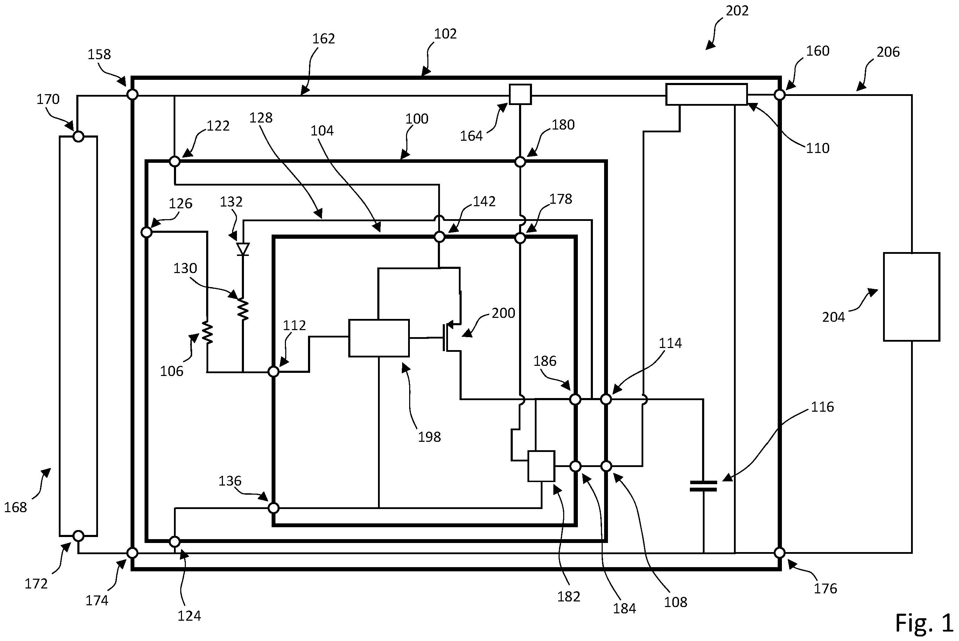

Figure 1 schematically illustrates an example of a system 202. The system 202 includes a battery 168 as an electrical energy source and an electrical load 204. The electrical load 204 can be coupled to the electrical battery 168 via a coupling string 206, so that the electrical load 204 can be supplied with electrical energy from the battery 168. The system 200 may also be referred to as a battery powered electrical system 202.

A battery connection unit 102 may be integrated into the coupling string 206. The battery connection unit 102 may be coupled to the battery 168. In addition, the battery connection unit 102 may be coupled to the electrical load 204. The battery connection unit 102 may serve to ensure coupling of the electrical load 204 to the battery 168. Other devices, elements and/or components may be integrated into the coupling string 206 (not shown).

The system 202 may further include a pyro switch 110. The pyro switch 110 may be integrated into the coupling string 206. The pyro switch 110 may also be referred to as a pyrotechnic cutoff switch. The pyro switch 110 may include an electrically explosive material. The pyro switch 110 may be configured so that the explosive material is ignited by a trigger signal. The ignition may cause an explosion that causes the rupture of an electrical connection in which the pyro switch is integrated.

In an example, the system 202 may form part of a motor vehicle. The electrical load 204 may represent a single load of the motor vehicle or a network of a plurality of loads of the motor vehicle. For example, the motor vehicle may be an electrically powered motor vehicle. The electrical voltage of the electric battery 168 of an electric vehicle may be more than 50 V, more than 100 V, or more than 200 V. In this case, the electric battery 168 may serve as a power source for the electric drive of the electric vehicle. The electric drive and associated components may form an electrical load 204. In this example, the pyro switch 110 may be used to quickly disconnect the electrical connection (via the coupling string 206) between the battery 168 and the electrical load 204, for example in the event of a malfunction of the system 202, in particular in the event of an accident.

Figure 1 also schematically illustrates an example of a control device 100. The control device 100 may be used for a battery connection unit 102. Figure 1 also schematically illustrates an example of the battery connection unit 102. The following explanations may refer to the battery connection unit 102 and/or the control device 100. In particular, the explanations relating to the battery connection unit 102 may apply in an analogous manner to the control device 100 even in the example if the control device 100 is configured independently of the battery connection unit 102. Furthermore, the explanations relating to the control device 100 may apply in an analogous manner to the battery connection unit 102, in particular in an example where the control device 100 may form a part of the battery connection unit 102.

The control device 100 includes an integrated circuit (IC) 104. In addition, the control device 100 includes a first reference impedance 106. The first reference impedance 106 may include a predefined ohmic resistor. In an example, the first reference impedance 106 is formed by a predefined resistor. The first reference impedance 106 does not form a part of the integrated circuit 104. The first reference impedance 106 and the integrated circuit 104 may be configured to be physically separate from each other. The control device 100 may include other parts and/or components.

The integrated circuit 104 includes a trigger output 108. The trigger output 108 is for coupling to the pyro switch 110. The integrated circuit 104 is configured to generate a trigger signal at the trigger output 108. The trigger signal may be configured to cause the pyro switch 110 to be triggered, in particular ignited. In an example, the trigger signal may be configured to transmit electrical power for the pyro switch 110 and also to represent the control signal to trigger the pyro switch. As an effect, the trigger signal may provide electrical power to the pyro switch 110 and cause the pyro switch 110 to trigger.

In an example, the integrated circuit 104 may be configured to receive at least one sensor signal. Further, the integrated circuit 104 may be configured to perform the generation of the trigger signal according to the at least one sensor signal. One of the sensor signals may represent electrical current in the coupling string 206. The integrated circuit 104 may be configured to monitor the current represented by the sensor signal. If the current exceeds a predefined value (predefined current threshold), the exceedance may be indicative of a malfunction of the system 202. In an example, the integrated circuit 104 may be configured to perform generation of the trigger signal in response to if and/or when the electrical current exceeds the predefined value. Otherwise, the integrated circuit 104 may not generate the trigger signal. In another example, a sensor signal may represent a mechanical acceleration, in particular the acceleration acting on the system 202. The integrated circuit 104 may be configured to monitor the acceleration represented by the sensor signal. Should the acceleration exceed a predefined value (predefined acceleration threshold), the exceedance may be an indication of a situation in which the pyro switch 110 should disconnect the corresponding electrical connection. In an example, the integrated circuit 104 may be configured to perform generation of the trigger signal in response to if and/or when the acceleration exceeds the predefined value. Otherwise, the integrated circuit 104 may not generate the trigger signal.

In an example, the integrated circuit 104 may be configured to be powered by the battery 168. The integrated circuit 104 may require electrical power to generate the trigger signal. In an example, the integrated circuit 104 may obtain the electrical energy required to generate the trigger signal from the battery 168. If and/or while a malfunction of the system 202 occurs, in an example, the situation may arise while the integrated circuit 104 is unable to draw electrical power from the battery 168, for example if an electrical connection for power supply between the battery 168 and the integrated circuit 104 is broken and/or if, in an example, the battery 168 is defective. Thus, there may be an advantage for the integrated circuit 104 to be able to be supplied with electrical energy via another energy source, in particular if the integrated circuit cannot draw electrical energy from the battery 168.

The integrated circuit 104 includes a driver output 186, which may also be referred to as a second driver output 186. Via the second driver output 186, the integrated circuit 104 may be coupled to an electrical capacitor 116, which may also be referred to as a reservoir capacitor 116. The reservoir capacitor 116 may be configured to store electrical energy. In an example, the reservoir capacitor 116 may be a second source of electrical energy for the integrated circuit 104.

The reservoir capacitor 116 is an electrical capacitor that may self-discharge over time. The self-discharge may be attributed to an often finite insulation of the dielectric of the electrical capacitor.

The system 202 may be configured to be enabled or disabled. In the deactivated state, the system 202 may have no or very low electrical power consumption. Often, individual components of the system 202 are deactivated or placed in a sleep mode for this purpose. If the system 202 changes from the deactivated state to the activated state, the plurality of components are activated at the same time. As the state is changed, the reservoir capacitor 116 should also be charged as quickly as possible so that the charged reservoir capacitor 116 is available as an alternative, electrical power source for the integrated circuit 104.

The reservoir capacitor 116 may be coupled to the integrated circuit 104 via the second driver output 186. In an example, the integrated circuit 104 may be used and/or configured to charge the reservoir capacitor 116 via the second driver output 186, beginning at the change from the disabled state of the system 102 to the enabled state. Rapid charging of the reservoir capacitor 116 provides the advantage that the reservoir capacitor 116 is available as an energy source for the integrated circuit 104 during the change of states, or very quickly after the change of states. However, rapid charging of the reservoir capacitor 116 may also have the disadvantage that a large current is required to rapidly charge the reservoir capacitor 116, and the large current may result in correspondingly high dissipation, particularly heat dissipation, in the integrated circuit 104. Against this background, a trade-off between a time for charging the reservoir capacitor 116 and a value of the charging current for charging the reservoir capacitor 116 may be considered. In some cases, the trade-off may be in favor of the charging time, where in other cases the trade-off may be in favor of a lower charging current. Against this background, there is a wish to be able to set a driver signal that can be generated by the integrated circuit 104 at the second driver output 186 as easily as possible and preferably without modifying the integrated circuit 104, so that the corresponding setting corresponds to the desired trade-off.

The integrated circuit 104 includes a reference input 112 for receiving a reference signal. Further, the integrated circuit 104 is configured to generate a driver signal at the driver output 186 according to the reference signal. The driver signal is used and/or configured to charge the reservoir capacitor 116, particularly if the reservoir capacitor 116 is coupled to the driver output 186. As an effect, without modifying the integrated circuit 104, it may be possible to use the reference signal to adjust the driver signal to charge the reservoir capacitor 116 and to achieve a desired trade-off between the charging time to charge the reservoir capacitor 116 and the value of the charging current to charge the reservoir capacitor 116. By adjusting the reference signal, the trade-off can be set either in favor of a shorter charging time or in favor of a lower charging current without making a structural change to the integrated circuit 104. As an effect, the complexity of the integrated circuit 104 and the cost of the integrated circuit 104 can be kept small, while flexibility in terms of customizability of the trade-off is still ensured. The control device 100 with the integrated circuit 104 can be used for many different applications without requiring customization of the integrated circuit 104.

In an example, the integrated circuit 104 may be configured to generate the driver signal at the driver output 114 such that the driver signal is in a predefined functional dependence according to the reference signal. In an example, the driver signal may be proportional to the reference signal, in particular with a maximum deviation of 15%. Instead of the proportional dependence, another predefined function can also represent the dependence of the driver signal on the reference signal. The dependence between the reference signal and the driver signal may relate to at least one electrical feature of the two signals. In an example, the dependency may relate to the electrical voltage, the electrical current, the electrical power, or another electrical feature of the signals. As an effect, the driver signal may be controlled via the integrated circuit 104 according to the reference signal.

Previously, it was explained that the control device 100 includes the integrated circuit 104 and the first reference impedance 106. The first reference impedance 106 does not form an integral part of the integrated circuit 104. The integrated circuit 104 and the first reference impedance 106 may be different and/or separate parts of the control device 100. The reference impedance 106 may be formed by one or more components. In an example, the first reference impedance 106 may be formed by at least one predefined electrical resistor.

The first reference impedance 106 is coupled to the reference input 112 of the integrated circuit 104. The purpose of coupling the first reference impedance 106 to the reference input 112 of the integrated circuit 104 may be understood to generate the reference signal at the reference input 112, wherein the reference signal depends on the first reference impedance 106. In an example, a current of the reference signal and/or a voltage of the reference signal at the reference input 112 may be changed via the first reference impedance 106. The current of the reference signal may also be referred to as the reference current. The voltage of the reference signal may also be referred to as the reference voltage.

In an example, a predefined electrical voltage may be applied between the terminal 126 of the control device 104 and the second battery terminal 124. The terminal 126 may also be referred to as the first interface terminal 126. The first reference impedance 106 may be coupled between the first interface terminal 126 and the first reference input 112. For example, if a resistance value of the first reference impedance 106 is decreased, then the reference current of the reference signal at the reference input 112 may increase. In the opposite example, if the resistance value of the first reference impedance 106 is increased, then the reference current of the reference signal at the first reference input 112 can decrease. The reference current of the reference signal at the first reference input 112 can be adjusted by adapting the resistance value of the first reference impedance 106. It is not necessary to adjust the integrated circuit 104 for the same purpose. Thus, the first reference impedance 106 provides a relatively easy way to adjust the reference current.

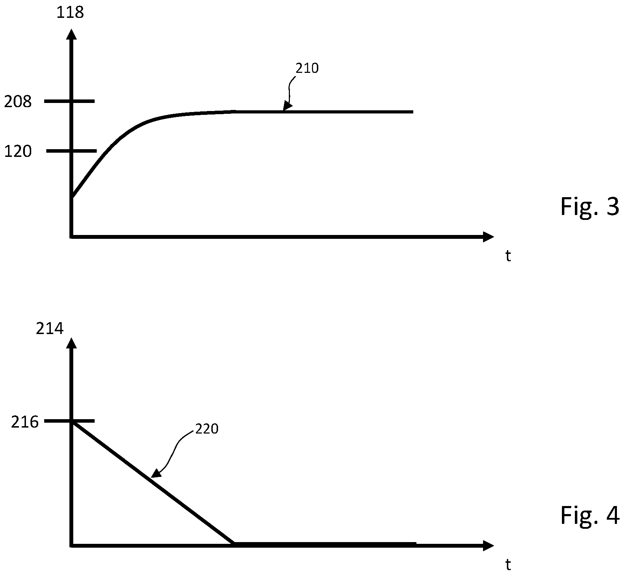

Previously, it was explained that the integrated circuit 104 is configured to be able to generate the driver signal at the driver output 186 of the integrated circuit 104 according to the reference signal. In an example, the integrated circuit 104 may be configured to generate a current of the driver signal at the driver output 186 according to the reference current of the reference signal. The driver signal current may also be referred to as a drive current 214 or a charge current. An example of the drive current 214 is schematically indicated in Figure 4. In an example, the integrated circuit 104 may be configured to generate the drive current 214 of the driver signal at the driver output 186 such that the drive current 214 is a predefined proportional relation to the reference current of the reference signal (in particular with an accepted deviation of less than 15%) and/or such that drive current 214 is an predefined functional relationship to the reference current (in particular with an accepted deviation of less than 15%). As an effect, adapting the resistance value of the first reference impedance 106 may adjust the reference current of the reference signal at the first reference input 112. Further, adapting the reference current via the adaptation of the resistance value of the first reference impedance 106 may cause an analog adaptation of the driver current 214 of the driver signal at the driver output 186. As a further effect, the adaptation of the resistance value of the first reference impedance 106 may cause an adjustment of the drive current 214. No adaptation of the integrated circuit 104 is necessary. The adaptation of the reference impedance 106 alone is sufficient to achieve an adaptation of the drive current 214. The control device 100 offers the advantage that the integrated circuit 104 can be designed to be inexpensive and compact, and that an adaptation of the drive current 214 for charging the reservoir capacitor 116 may be achieved simply by adjusting the first reference impedance 106, which may be also inexpensive and requiring low effort.

In an example, the driver output 186 of the integrated circuit 104 may also be referred to as the second driver output 186. The second driver output 186 may be coupled to a first driver output 114 of the control device 100. In an example, the first driver output 114 of the control device 100 may be formed and/or provided by the second driver output 186 of the integrated circuit 104. In an example, if the reservoir capacitor 116 is coupled to the first driver output 114 of the device 100, said coupling may also simultaneously cause the reservoir capacitor 114 to be coupled to the second driver output 186 of the integrated circuit 100.

In an example, a second battery terminal 124 of the device 100 may be coupled to a terminal 136, also referred to as a second supply voltage terminal 136, of the integrated circuit 104. In an example, the terminal 136 of the integrated circuit 104 may form and/or provide the second battery terminal 124 of the device 100.

In an example, the integrated circuit 104 is configured to be supplied with electrical energy from the reservoir capacitor 116 via the second driver output 186. Said energy may also be referred to as capacitor energy. The reservoir capacitor 116 may be coupled between the first driver output 114 and the second battery terminal 124. The reservoir capacitor 116 may also be coupled to the second driver output 186 of the integrated circuit 104 via the first terminal output 114. The reservoir capacitor 116 may also be coupled to the terminal 136 of the integrated circuit 104 via the second battery terminal 124. In an example, the integrated circuit 104 may be configured to be supplied with electrical power from the reservoir capacitor 116 via the second driver output 186 and the terminal 136. As an effect, the integrated circuit 104 may also be supplied with electrical power (capacitor power) via the reservoir capacitor 116 in the event, for example, of a malfunction of the system 202. For example, if an interruption occurs between the battery 168 and the integrated circuit 104 due to a fault, such as a mechanical disconnection of a power supplying connection, then the integrated circuit 104 may continue to run on electrical energy provided by the reservoir capacitor 116.

In an example, the integrated circuit 104 may be configured to be able to generate the trigger signal at the trigger output 108, 184 in the case where the integrated circuit 104 is powered solely by electrical power provided via the second driver output 186 and the second supply voltage terminal 136. As an effect, the integrated circuit 104 may be configured to be able to (also) generate the trigger signal at the trigger output 108, 184 if the integrated circuit 104 is powered solely by capacitor energy from the reservoir capacitor 116. Should an interruption occur between the battery 168 and the integrated circuit 104 due to a fault, the integrated circuit 104 powered by capacitor energy can continue to be able to generate the trigger signal to trigger the pyro switch 110. The triggering of the pyro switch 110 may cause an interruption between the electrical load 204 and the battery 168. As an effect, the safety of the system 202 can be improved.

In an example, the integrated circuit 104 may include a signal generator 182, which may also be referred to as a trigger signal generator 182. The signal generator 182 of the integrated circuit 104 may be configured to, in particular configured to be able to, generate the trigger signal. The signal generator 182 may be coupled to a second trigger output 184 of the integrated circuit 104. The second trigger output 184 of the integrated circuit 104 may be coupled to the trigger output 108 of the control device 100. In an example, the second trigger output 184 of the integrated circuit 104 may form and/or provide the trigger output 108 of the control device 100. The signal generator 182 may be coupled to the second driver output 186 and to the terminal 136. The signal generator 182 may be supplied with electrical power, in particular from the reservoir capacitor 116, via the second driver output 186 and the terminal 136. In addition, the signal generator 182 may be coupled to another terminal 178 of the integrated circuit 104, wherein the terminal 178 may also be referred to as a first sensor terminal 178. The integrated circuit 104, in particular the associated signal generator 182, can receive a sensor signal via the first sensor terminal 178. The sensor signal may be, for example, a current sensor signal representing a value of electrical current through the connection string 162. The first sensor terminal 178 may be coupled to a second sensor terminal 180 of the control device 100. In an example, the first sensor terminal 178 may form and/or provide the second sensor terminal 180. The second sensor terminal 180 may be coupled to a sensor 164. The sensor 164 may be a current sensor configured to detect current through the connection string 162. The current sensor 164 may be configured to generate the sensor signal as a current sensor signal representing the value of the electrical current through the connection string 162.

In an example, a sensor other than the current sensor 164 may be coupled to the second sensor terminal 180. For example, an acceleration sensor may be provided for the battery connection unit 102 that is coupled to the second sensor terminal 180. The acceleration sensor may be configured to detect an acceleration of the battery connection unit 102. Further, the acceleration sensor may be configured to generate a sensor signal representing the detected acceleration.

The signal generator 182 may be configured to either trigger or not trigger the generation of the trigger signal based on the sensor signal received via the first sensor terminal 178. In an example, the signal generator 162 may trigger the generation of the trigger signal only if a sensor value represented by the sensor signal exceeds a predefined threshold value. Otherwise, the signal generator 162 may be configured not to trigger the generation of the trigger signal.

It has previously been explained that the integrated circuit 104 may be configured to generate a driver signal at the driver output 186 suitable for charging the reservoir capacitor 116, provided that the reservoir capacitor is coupled to the driver output 186 or coupled to the driver output 186 via the further driver output 114.

Figure 3 schematically illustrates an example of a charge curve 210 representing an example of a state of charge 118 of the reservoir capacitor 116 over time t. Figure 4 schematically illustrates an example of a current curve 220 representing an example of the drive current 214 over time t. The current curve 220 and the charge curve 210 may be associated with each other. Based on the drive current 214 according to the current curve 220, the state of charge 118 of the reservoir capacitor 116 may evolve according to the charge curve 210. In an example, the current curve 220 begins with an initial value 216, and the integrated circuit 104 may be configured to generate the initial value 216 of the drive current 214 based on the reference current of the reference signal at the first reference input 112. Due to the drive current 214, the state of charge 118 of the reservoir capacitor 116 may increase, as schematically illustrated, for example, in the charge curve 210. As drive current 214 decreases, the state of charge 118 may increase with a more moderate slope, as shown schematically, for example, in the charge curve 220. However, the shape of the charge curve 220 may depend in particular on the initial value 216 of the charging current 214 and, as a logical consequence, on the reference current of the reference signal. As an effect, the integrated circuit 104 may generate the drive current 214 according to the reference current.

It can also be recognized from the charge curve 210 and the current curve 220 that the state of charge 118 may be in a functional relationship to the drive current 214. The smaller the driver current 214 along the current curve 220, the greater the state of charge 118 along the charge curve 210. As an effect, the state of charge 118 may be inferred from the driver current 214. In an example, the functional relationship between the drive current 214 and the state of charge 118 may be stored by the integrated circuit 104.

In an example, the integrated circuit 104 is configured to determine the state of charge 118 of the reservoir capacitor 116 based on the drive current 214. To determine the state of charge 118, the integrated circuit 104 may further utilize the initial value 216 of the drive current 214. The initial value 214 of the drive current 214 may be determined and/or controlled by the reference current of the reference signal. The integrated circuit 104 may also use the reference current of the reference signal to determine the state of charge 118. It was previously explained that the state of charge 118 may be in a functional relationship to the drive current 214. To determine the state of charge based on the drive current 214, the integrated circuit 104 may use the functional relationship between the currents.

In an example, the integrated circuit 104 is configured such that the integrated circuit 104 is capable of generating the trigger signal at the trigger output 184 if the state of charge 118 of the reservoir capacitor 116 has reached at least a predefined reference state of charge 120. The reference state of charge 120 may represent, for example, that the reservoir capacitor 116 is charged to 60 %, 70 %, 80 % or 90 %. At 100 %, the reservoir capacitor 116 would be fully charged. Once the state of charge 118 of the reservoir capacitor 116 reaches the reference state 120, in an example, the electrical voltage and/or electrical energy provided by the reservoir capacitor 116 may be sufficient to power the integrated circuit 104 such that the integrated circuit 104 is capable and/or ready to be able to generate the trigger signal at the trigger output 184. If the charge state 118 of the reservoir capacitor 114 is greater than the reference state 120, then the integrated circuit 104 is capable and/or ready to be able to generate the trigger signal at the trigger output 184. If the charge state 118 of the reservoir capacitor 114 is less than the reference state 120, then in an example, the integrated circuit 104 is not capable and/or not ready to be able to generate the trigger signal at the trigger output 184. In the latter case, for example, the electrical voltage and/or energy provided by the reservoir capacitor 116 may not be sufficient to enable the integrated circuit 104 to generate the trigger signal at the trigger output 184.

If the integrated circuit 104 is capable to generate the trigger signal at the trigger output 184 does not mean that the integrated circuit 104 must actually generate the trigger signal. If the integrated circuit 104 is capable, in particular in terms of ready, to generate the trigger signal, then the integrated circuit 104 has the ability to trigger the trigger signal without actually having to trigger it.

The triggering of the trigger signal can be performed via the integrated circuit 104 according to a sensor signal. In this context, reference is made to the preceding explanations.

In an example, the control device 100 includes the first battery terminal 122 and the second battery terminal 124. The integrated circuit 104 may be coupled to the first battery terminal 122 and the second battery terminal 124. A signal connection may extend from the first supply voltage terminal 142 of the integrated circuit 104 to the first battery terminal 122 of the control device 100. Further, another signal connection may extend from the second supply voltage terminal 136 of the integrated circuit 104 to the second battery terminal 124 of the control device 100. In an example, the battery 168 is configured to provide the battery voltage across a first battery connector 170 of the battery 168 and a second battery connector 172 of the battery. The battery voltage may be provided by the battery between the first and second battery connector 170, 172. The first battery connector 170 may be connected to the first battery input terminal 158 of the battery connection unit 202, wherein the second battery connector 172 may be connected to the second battery input terminal 174. The first battery terminal of the control device may be connected to the first battery input terminal 158. The second battery terminal 124 of the control device 100 may be connected to the second battery input terminal of the battery connection unit 102. As an effect, the control device 100 may be provided with an electrical voltage via the first battery terminal 122 and the second battery terminal 124. As a further effect, the battery 168 may be indirectly coupled to the first and second battery terminals 122, 124 such that the battery voltage provided by the battery 168 drops between the first battery terminal 122 and the second battery terminal. In an example, the battery voltage may also drop between the first and second supply voltage terminals 142, 136 of the integrated circuit 104. The integrated circuit 104 may also be supplied with the battery voltage.

The control device 100 may further include another terminal 126, also referred to as a first interface terminal 126. The control device 100 may be configured to receive a signal, also referred to as a first base signal, at the interface terminal 126. The first base signal may include a constant predefined first voltage, which may also be referred to as a base voltage. Further, the first reference impedance 106 may be coupled between the first interface terminal 126 of the control device 100 and the first reference input 112 of the integrated circuit 104. In an example, the first reference impedance 112 may be integrated into an electrical connection extending from the first interface terminal 126 to the first reference input 112.

The first base voltage of the first base signal may be adapted according to a voltage level at the second battery terminal 124. The first base voltage may represent a voltage that drops between the first interface terminal 126 and the second battery terminal 124. A desired reference signal may be generated at the first reference input 112 by a selection of the first base voltage of the first base signal and/or by a selection of the first reference impedance 106. In an example, a voltage source may be coupled between the first interface terminal 126 and the second battery terminal 124 such that the base voltage drops between the first interface terminal 126 and the second battery terminal 124. The voltage provided by said voltage source may be less than the battery voltage of the battery 168. The first reference impedance 106 may be formed by a suitable design of the control device 100. As an effect, the reference signal can be easily adjusted via the first reference impedance 106 and the base voltage without having to customize the integrated circuit 104.

Figure 1 schematically illustrates an example of the control device 100. As can be seen from the example of the control device 100, at least one unit 198 of the integrated circuit 104 may be coupled between the first reference input 112 and the second supply voltage terminal 136. The unit 198 may also be referred to as the main unit 198. The unit 198 may include a plurality of components.

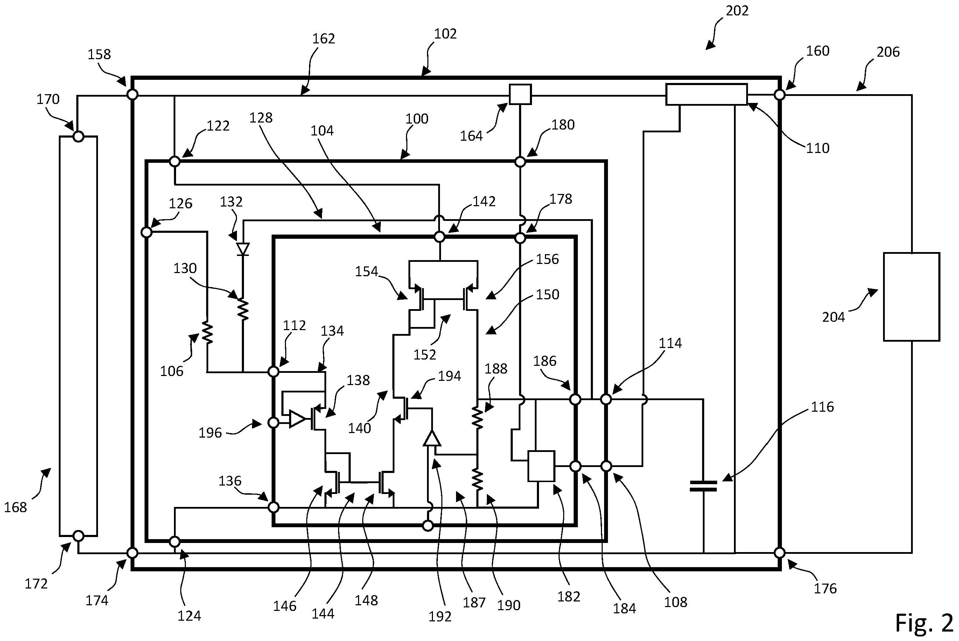

Figure 2 schematically illustrates another example of a system 202 and another example of a control device 100. The further explanations of the control device 100 may also apply independently of the system 202. In an example, the control device 100 may be a separate device that is independent of the system 202. In another example, the control device 100 may form a part of the system 202. The following explanations may apply all examples in an analogous manner.

In an example, the integrated circuit 104 may be configured to generate a predefined voltage as the reference voltage of the reference signal at the first reference input 112 of the integrated circuit 104. The integrated circuit 104 may include a first circuit string 134 extending from the first reference input 112 to the second supply voltage terminal 136. In an example, a voltage regulation unit 138 may be integrated into the first circuit string 134. The voltage regulation unit 138 may be configured to adjust an electrical resistance for the first circuit string 134 such that the reference voltage of the reference signal is present at the first reference input 112. If the voltage level at the first reference input 112 becomes smaller that the predefined reference voltage when the reference signal is applied to the first reference input 112, the voltage control unit 138 may increase the electrical resistance in the first circuit string 134 until said voltage level corresponds to the predefined reference voltage. In an example, if the voltage level at the first reference input 112 becomes higher that the predefined reference voltage, the voltage control unit 138 may decrease the electrical resistance in the first circuit string 134 until said voltage level corresponds to the predefined reference voltage. In an example, the integrated circuit 104 may therefore be configured to set the reference voltage to a predefined constant voltage. The predefined voltage as the reference voltage provides the advantage that the reference current of the reference signal can be used (in particular alone) to cause a corresponding change in the driver signal, in particular the drive current of the driver signal. As an effect, the driver signal, in particular the driver current of the driver signal, can be controlled via the reference current of the reference signal. The reference current of the reference signal can be controlled via the first reference impedance 106. It is possible to adjust the first reference impedance 106 with little effort without having to change the integrated circuit 104. As an effect, an adjustment of the drive current of the drive signal as can be achieved with little effort and low cost, while being particularly easily adjustable for different use cases and applications.

In an example, the integrated circuit 104 may be configured to control a drive current of the driver signal at the driver output 186 according to the reference current of the reference signal at the first reference input 112. As an effect, the reference current may be used to change the driver current of the driver signal without changing the integrated circuit 104. For example, a higher driver current for quicker charging of the reservoir capacitor 116 may be reached via adapted the reference current through a corresponding adaptation of the first reference impedance 106. As an effect, it is just the adaptation of the first reference impedance 106 required, in order to achieve a quicker charge of the reservoir capacitors 116 and/or a desired balanced charge of the reservoir capacitor 116.

In an example, the integrated circuit 104 may be configured to control the drive current of the drive signal such that the drive current is proportional to the reference current. As an effect, an increase in the reference current may result in a proportional increase in the drive current. In an example, there may be a predefined factor K representing the proportional relationship between the reference current and the driver current. The drive current may be K times the reference current. Due to, for example, manufacturing tolerances or other deviations, there may be a small deviation in the proportional ratio between the reference current and the drive current. In an example, the integrated circuit 104 may be configured to control the drive current according to the reference current such that the drive current is in a predefined ratio to the reference current, but with an allowable deviation of less than 10%, less than 15%, or less than 20%. As an effect, the actual ratio between the reference current and the driver current may deviate from the predefined ratio by less than 10%, less than 15% or less than 20%. The limited allowable deviation allows the drive current to be adjustable by a simple, inexpensive and sufficiently precise adjustment of the first reference impedance 106.

In an example, the integrated circuit 104 includes a second circuit string 140. The second circuit string 140 may extend from the first supply voltage terminal 142 of the integrated circuit 104 to the second supply voltage terminal 136. In addition, the integrated circuit may include a first current mirror circuit 144. The first current mirror circuit 144 may include two transistors 146, 148, which may be referred to as a first sensor transistor 146 and a first mirror transistor 148. The first sensor transistor 146 may be integrated into the first circuit string 134. The first mirror transistor 148 may be integrated into the second circuit string 140. Further, the first mirror transistor 148 may be coupled to the first sensor transistor 146 such that the first mirror transistor 148 causes an electrical current, referred to as an inter-string current, in the second circuit string 140 that is in a predefined, first ratio to the reference current. The reference current flows through the first circuit string 134. A deviation of less than 10%, less than 15% or less than 20% may be allowed for the first ratio. As an effect, the inter-circuit current in the second circuit string 140 may be controlled by the reference current in the first circuit string 134 so that the inter-circuit current is at the first ratio to the reference current, but in particular with an allowable deviation of less than 10%, less than 15%, or less than 20% from the first ratio.

In an example, the integrated circuit 104 includes a third circuit string 150. The third circuit string 150 may extend from the first supply voltage terminal 142 to the driver output 186. In addition, the integrated circuit 104 may include a second current mirror circuit 152. The second current mirror circuit 152 may include two transistors 154, 156, which may be referred to as a second sensor transistor 154 and a second mirror transistor 156. The second sensor transistor 154 may be integrated into the second circuit string 140. The second mirror transistor 156 may be integrated into the third circuit string 150. Further, the second mirror transistor 156 may be coupled to the second sensor transistor 154 such that the second mirror transistor 156 causes the drive current in the third circuit string 150 to be at a predefined second ratio to the inter-circuit current. A deviation of less than 10 %, less than 15 % or less than 20 % may be allowable for the second ratio. As an effect, the drive current in the third circuit string 150 may be controlled by the inter-circuit current in the second circuit string 140 so that the drive current is in the second ratio to the inter-circuit current, but in particular with an allowable deviation of less than 10 %, less than 15 %, or less than 20 % from the second ratio. Previously, it was shown that the inter-circuit current can be controlled via the reference current, so that the inter-circuit current is in particular in the first ratio to the reference current. As an effect, the drive current may also depend on the reference current. In an example, the drive current may depend on the reference current in a ratio resulting from the product of the first ratio and the second ratio.

The two current mirror circuits 144, 152 provide the advantage that an electrical power for charging the reservoir capacitor 116 does not need to be provided through the first reference input 112, but instead the corresponding power can be provided through the first and second supply voltage terminals 142, 136. As an effect, the reference current of the reference signal can be set particularly easily and precisely, in particular via the first reference impedance 106.

Previously, it was explained that Figure 3 schematically illustrates an example of the charge curve 210 for the reservoir capacitor 116. The higher the state of charge 118, the higher the voltage provided by the reservoir capacitor 116. If the reservoir capacitor 116 is coupled between the first driver output 114 and the second battery terminal 124, then the voltage of the reservoir capacitor 116 drops between the driver output 114 and the second battery terminal 124. In an example, if a charge level 118 of the reservoir capacitor 116 has reached the reference charge level 120, the voltage provided by the reservoir capacitor 116 may be sufficient to operate the integrated circuit 104, in particular to operate the integrated circuit 104 such that the integrated circuit 104 is capable of generating the trigger signal at the trigger output 184. In an example, if the reference charge state 120 is reached, the voltage provided by the reservoir capacitor 116 may be sufficiently high to operate the trigger signal generator 182 of the integrated circuit 104 such that the trigger signal generator achieves the capability of generating the trigger signal at the trigger output 184.

Capacitors often have a dielectric with a finite insulation effect. The finite insulation effect may cause a capacitor to self-discharge over time. Against this background, it is desired that the reservoir capacitor 116 be recharged if the voltage provided by the reservoir capacitor 116 drops to or below a predefined voltage, referred to as the first threshold voltage.

In an example, the integrated circuit 104 may include another transceiver 194, referred to as a switching transceiver 194. The switching transceiver 194 may be integrated into the second circuit string 140 of the integrated circuit 104. Further, the integrated circuit 104 may be configured to control the switching transceiver 194 according to a voltage of the driver signal, also referred to as a driver voltage of the driver signal, such that the switching transceiver 194 changes to a closed state if and/or once the driver voltage is less than a predefined first threshold voltage, and otherwise such that the switching transceiver 194 switches to and/or is in the open state.

In an example, the integrated circuit 104 may include a monitoring unit 187. The monitoring unit 187 may be coupled to the driver output 186 of the integrated circuit 104 and, in particular, to the second supply voltage terminal 136 of the integrated circuit 104. The monitoring unit 187 may be configured to measure the driver voltage of the driver signal at the driver output 186. Further, the monitoring unit 187 may be configured to control the switching transceiver 194 such that the switching transceiver changes to the closed state if and/or once the driver voltage is less than the predefined first threshold voltage, and otherwise control the switching transceiver 194 such that the switching transceiver 194 is in the open state. The monitoring unit 187 may include another terminal via which monitoring unit 187 may receive a second threshold voltage. The monitoring unit 187 may include a measuring string in which a third impedance 188 and a fourth impedance 190 are integrated. The measurement string may be coupled between the driver output 186 and the second supply voltage terminal 136.

In addition, the monitoring unit 187 may include a comparator 192. The comparator 192 may be coupled to a node of the measurement string, wherein the node is disposed between the third impedance 188 and the fourth impedance 190. Further, the comparator 192 may be coupled to the terminal of the monitoring unit 187 so that the second threshold voltage may be provided to the comparator 192. The comparator 192 may be configured to compare the second threshold voltage with a voltage at the node of the measuring line. The voltage at the node of the measurement line is also referred to as the measurement voltage. The measurement voltage may represent the drive voltage of the drive signal. If the reservoir capacitor 116 is coupled to the driver output 114, then the driver voltage may correspond to the voltage of the reservoir capacitor 116. As an effect, the measurement voltage may represent the voltage of the reservoir capacitor 116. In an example, the measurement voltage may be less than the voltage of the reservoir capacitor 116 by a predefined factor or less than the driver voltage by the predefined factor. Similarly, the second threshold voltage may be less than the first threshold voltage by the predefined factor. The output of the comparator 192 may be coupled to the switching transistor 194 such that the comparator 192 can control the switching transistor 194. In an example, the comparator 192 may control the switching transistor 194 to either a closed state or an open state. The comparator 192 may be configured to control the switching transistor 194 such that the switching transistor 194 changes to the closed state if and/or once the measurement voltage is less than the second threshold voltage, and to control the switching transistor 194 such that the switching transistor 194 is otherwise in the open state.

In an example, the switching device 100 includes an electrical connection string 128, which may also be referred to as a feedback string 128 or feedback loop 128. The feedback string 128 may extend from the second driver output 186 of the integrated circuit 104 to the first reference input 112 of the integrated circuit 104. The feedback loop 128 may extend outside of the integrated circuit 104. In an example, the feedback string 128 is at least partially or completely external to the integrated circuit 104. A predefined second reference impedance 130 may be integrated into the feedback string 128. The second reference impedance 130 may also be arranged outside the integrated circuit 104. The second reference impedance 130 may include a predefined ohmic resistor. In an example, the second reference impedance 130 is formed by a predefined resistor. The switching device 100 may further include a diode 132 integrated into the feedback string 128. A forward direction of the diode 132 may be directed towards the first reference input 112. As an effect, a current, also referred to as feedback current, may flow from the second driver output 186 to the first reference input 112 via the feedback string 128, but not in the reverse direction.

Previously, it was explained that the first reference input 112 of the integrated circuit 104 is configured to receive the reference signal. The current of the reference signal may also be referred to as the reference current. In the above example, the reference current may include two components. For example, a first component of the reference current may be understood to be the current flowing through the first reference impedance 106 to the first reference input 112. The first reference impedance 106 may be coupled between the first interface terminal 126 and the first reference input 112. As an effect, the current through the first reference impedance 106 and/or the first component of the reference current may be controlled by a voltage at the first interface terminal 126 and/or the first reference impedance 106. A second component of the reference current may be understood, for example, as the current through the feedback string 128.

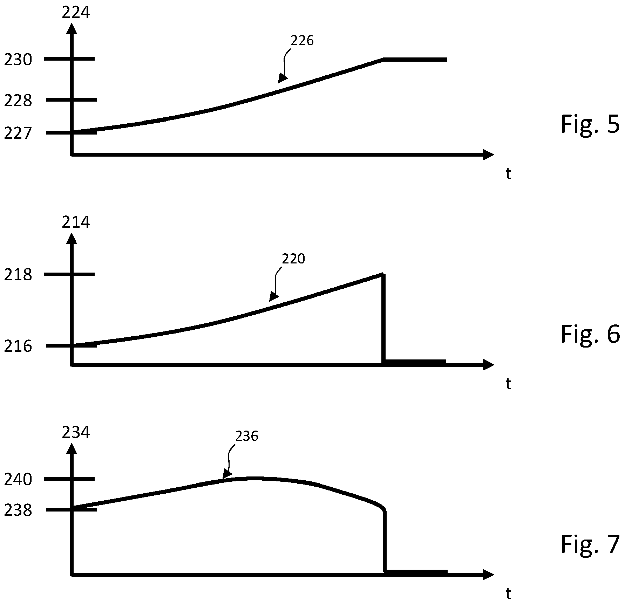

Figure 5 schematically illustrates an example of a voltage curve 226 of the voltage 224 of the reservoir capacitor 116. The voltage 224 of the reservoir capacitor 116 may also be referred to as the capacitor voltage 224. The capacitor voltage may drop between the first driver output 114 and the second battery terminal 124. As an effect, the capacitor voltage 224 may also drop between the second driver output 186 and the second supply voltage terminal 136.

In an example of the control device 100 shown schematically in Figure 2, it has already been explained that the third circuit string 150 may extend between the first supply voltage terminal 142 and the second driver terminal 186. The second mirror transistor 156 may be integrated into the third circuit string 150. As an effect, the third mirror transistor 156 may be used to control the drive current 214 at the second driver output 186. As the capacitor voltage of the reservoir capacitor 116 increases (corresponding to the voltage of the driver signal), the voltage drop across the second mirror transistor 156 decreases. The voltage dropped across the second mirror transistor 156 may also be referred to as the transistor voltage. During a charging process of the reservoir capacitor 116, the capacitor voltage 224 will increase. This effect is shown schematically in Figure 5 by the voltage curve 226. The capacitor voltage 224 of the reservoir capacitor 116 may include a certain associated initial value 227 at the beginning of a charging process. Similarly, the transistor voltage across the third mirror transistor 156 may also include a specific associated initial value at the beginning of a charging process. In an example, the capacitor voltage 224 increases during the charge process while the transistor voltage decreases. As an effect, a lower electrical power would be transmitted via the third mirror transistor 156. The decreasing electrical power for charging the reservoir capacitor 116 may be at least partially compensated via the feedback string 128. The greater the capacitor voltage 224 becomes during the charging process, the greater a voltage drop across the second reference impedance 130 becomes and the higher the second component of the reference current becomes. As an effect, the feedback string 128 may serve to increase the reference current as the capacitor voltage 224 increases.

Previously, it was explained that the integrated circuit 104 may be configured to generate the drive current of the driver signal at the second driver output according to the reference current of the reference signal at the first reference input 112. In an example, if the feedback string 128 increases the reference current as the capacitor voltage 224 increases, the effect may be that the driver current 214 also increases as the capacitor voltage 224 increases. As another effect, the drive current 214 may increase during the charging process of the reservoir capacitor 116. Figure 6 schematically illustrates an example of the increasing drive current 214 being under the influence of the feedback string 128.

Figure 7 schematically illustrates an example of the electrical power 234 transferred to the reservoir capacitor during the charge process. The electrical power 234 may also be referred to as transfer power 234. It was previously explained that the transistor voltage across the second mirror transistor 156 decreases as the capacitor voltage 224 increases. As an effect of the decreasing transistor voltage and the increasing drive current 214 during the charging process, the electrical power 234 transferred to the reservoir capacitor 216 may be achieved to be approximately constant or have only a small deviation between an initial value 238 and a maximum value 240 during the charging process of the reservoir capacitor 116. In an example, the variation of the transmission power 234 over time is represented by the power curve 236 schematically shown in Figure 7. In an example, the maximum value 240 of the transfer power 234 may deviate from the initial value 238 by less than 25%, less than 20% or less than 15%.

A power dissipation and/or heat generation at the second mirror transistor 156 may depend on the transfer power 234. In particular, level of the power dissipation may be given at a acceptable high level without extending to a too high level while allowing a quick charge of the reservoir capacitor 116. Furthermore, a curve (not shown) of the power dissipation may be similar to the curve of the transfer power 234. Previously, it was explained that the transfer power during the charging process of the reservoir capacitor 116 may be controlled through the feedback string 128 such that only a small deviation from an initial value 238 of the transfer power 234 is achievable. As an effect, the power dissipation and/or a heat generation at the second mirror transistor 156 also changes only slightly during the charging process of the reservoir transistor 116. As another effect, the second mirror transistor 156 may be utilized more efficiently during the charging process of the reservoir transistor 116. At the same time, the reservoir capacitor 116 can be charged faster. To reduce the charging time for charging the reservoir capacitor 116, it is not necessary to increase the size of the structure of the second mirror transistor 156 in particular, since the heat generation at the second storage transistor 156 varies only slightly. As a further effect, a threshold voltage 228 of the capacitor voltage 234 is achieved faster and more efficiently, wherein the threshold voltage 228 may correspond to a reference state 120 of the reservoir capacitor 116. As another effect, the feedback string 128 may positively assist in achieving the reference state 120 faster, more efficiently, and with acceptable heat generation at the second mirror transistor 156.

Figures 1 and 2 schematically illustrate two examples of a battery connection unit 102. The battery connection unit 102 may include the control device 100 and the reservoir capacitor 116. The battery connection unit 102 may include the first battery input terminal 158 and the first battery output terminal 160. Further, the battery connection unit 102 may include the pyro switch 110. The pyro switch 110 may be integrated into a connection string 162, which may extend from the first battery input terminal 158 to the first battery output terminal 160. The pyro switch 110 may be coupled to the control device 110, in particular to a first trigger output 108 of the control device 110. The first trigger output 108 of the control device 110 may be coupled to the second trigger output 184 of the integrated circuit 104. The integrated circuit 104 and/or the control device 110 may be configured to have the ability to generate a trigger signal at the first and/or second trigger output 108 using electrical energy from the reservoir capacitor 116.

In an example, the battery connection unit 102 may include a current sensor 164. The current sensor 164 may be a configured to detect a current running through the connection string 162. The current sensor 164 may be configured to generate a current sensor signal that represents the value of the electrical current through the connection string 162. The current sensor 164 may be coupled to a second sensor terminal 180 of the control device 100. The second sensor terminal 180 may be coupled to a first sensor terminal 178 of the integrated circuit 104. In an example, the second sensor terminal 178 of the integrated circuit 104 may form the first sensor terminal 180 of the control device 100. The current sensor 164 may be configured to transmit the current sensor signal to the second and/or first sensor terminal 180, 178. The integrated circuit 104 may be configured to generate the trigger signal to trigger the pyro switch 110 in response to if and/or only once the current sensor signal representing a battery current through the connection string 162 that meets or exceeds a predefined threshold.

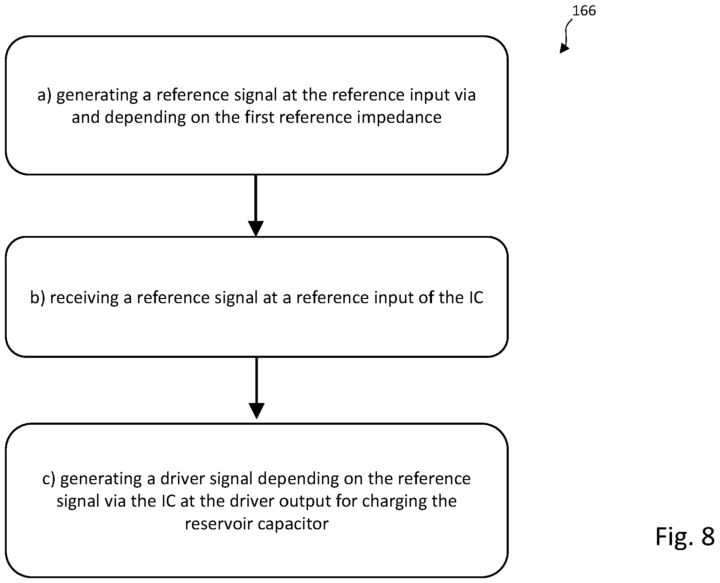

Figure 8 schematically illustrates an example of a method 166 for the control device 100.

For the method, reference is made to the advantageous explanations, preferred features, technical effects and advantages in an analogous manner as previously explained for the integrated circuit 104, the control device 100, and/or the battery connection unit 102.

In an example, the method 166 includes the following steps:
a) generating a reference signal at the reference input via and depending on the first reference impedance,
b) receiving a reference signal at a reference input of the IC, and
c) generating a driver signal depending on the reference signal via the IC at the driver output for charging the reservoir capacitor.

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

## Claims

1. A **control device** for a battery connection unit, the control device comprising:
an integrated circuit, IC, and
a first reference impedance,
wherein the IC comprises a trigger output for coupling to a pyro switch,
wherein the IC is configured to generate at the trigger output a trigger signal for triggering the pyro switch,
wherein the IC comprises a reference input for receiving a reference signal,
wherein the first reference impedance is coupled to the reference input to generate the reference signal at the reference input depending on the first reference impedance,
wherein the IC comprises a driver output for coupling to a reservoir capacitor, and
wherein the IC is configured to generate a driver signal at the driver output for charging the reservoir capacitor according to the reference signal.

2. The control device according to the preceding claim, wherein the IC is configured to be supplied with capacitor energy from the reservoir capacitor via the driver output, and wherein the IC is configured to be powered by the capacitor energy to generate the trigger signal.

3. The control device according to any of the preceding claims, wherein the IC is configured to detect a state of charge of the reservoir capacitor based on the driver signal and/or the reference signal, and wherein the IC is configured to be ready to generate the trigger signal at the trigger output as soon as the charge state of the reservoir capacitor reached at least a predefined reference charge state.

4. The control device according to any of the preceding claims, wherein the control device comprises a first battery terminal and a second battery terminal, wherein the IC is coupled to the first and second battery terminals, wherein the control device comprises a first interface terminal, wherein the control device is configured to receive a predefined first base voltage at the first interface terminal, and wherein the first reference impedance is coupled between the first interface terminal and the reference input of the IC.

5. The control device according to any of the preceding claims, wherein the IC is configured to generate a predefined voltage as a reference voltage of the reference signal at the reference input of the IC.

6. The control device according to any of the preceding claims, wherein the IC is configured to control a drive current of the drive signal according to a reference current of the reference signal.

7. The control device according to any of the preceding claims, wherein the IC is configured to control the drive current such that the drive current is proportional to the reference current, in particular in a predetermined ratio with a permissible deviation of less than 15%.

8. The control device according to any of the preceding claims, wherein the control device comprises a feedback loop coupled between the driver output of the IC and the reference input of the IC, and wherein a second reference impedance is integrated in the feedback loop.

9. The control device according to the preceding claim, wherein a diode is integrated into the feedback line, and wherein a forward direction of the diode in the feedback loop is directed from the driver output to the reference input.

10. The control device according to any of the preceding claims, wherein the IC comprises a first circuit string extending from the reference input of the IC to a second supply voltage terminal (ground) of the IC, and wherein a voltage regulation unit is integrated into the first circuit string, wherein the voltage regulation unit is configured to limit a voltage at the reference input of the IC to the second reference voltage.

11. The control device according to the preceding claim, wherein the IC comprises a second circuit string extending from a first supply voltage terminal of the IC to the second supply voltage terminal, wherein the IC comprises a first current mirror circuit comprising two transistors referred to as a first sensor transistor and a first mirror transistor, wherein the first sensor transistor is integrated into the first circuit string, wherein the first mirror transistor is integrated into the second circuit string, wherein the first mirror transistor is coupled to the first sensor transistor such that the first mirror transistor causes an intermediate string current in the second circuit string which is in a predefined first ratio to the reference current, wherein the IC comprises a third circuit string extending from the first supply voltage terminal to the driver output, wherein the IC comprises a second current mirror circuit comprising two transistors referred to as the second sensor transistor and the second mirror transistor, wherein the second sensor transistor is integrated into the second circuit string, wherein the second mirror transistor is integrated into the third circuit string, and wherein the second mirror transistor is coupled to the second sensor transistor such that the second mirror transistor causes the drive current in the third circuit string to be in a predefined second ratio to the intermediate string current.

12. A **battery connection unit** comprising: a control device according to any of the preceding claims, and a reservoir capacitor coupled to the driver output.

13. The battery connection unit according to the preceding claim, wherein the battery connection unit further comprises: a battery input terminal, a battery output terminal, a pyro switch, wherein a connection string extends from the battery input terminal to the battery output terminal, wherein the pyro-switch is integrated into the connection string, wherein the pyro-switch is coupled to the control device such that the reservoir capacitor provides electrical energy to the pyro-switch for triggering, wherein the IC is coupled to the pyro switch, and wherein the IC is configured to be ready to generate a triggering signal at the triggering output for triggering the pyro switch once the state of charge of the reservoir capacitor has reached at least a predefined reference state of charge.

14. The battery connection unit according to the preceding claims, wherein the battery connection unit comprises a current sensor for measuring a battery current in the connection string, wherein the current sensor is coupled to the IC, wherein the IC is configured to generate the trigger signal for triggering the pyro switch in response that the battery current reaches or exceeds a predefined threshold current value.

15. A **method** for a control device comprising an integrated circuit, IC, and a first reference impedance, the IC comprising a trigger output for coupling to a pyro-switch, the IC comprising a reference input, the first reference impedance being coupled to the reference input, the IC comprising a driver output, the IC comprising a driver output for coupling to a reservoir capacitor, the IC is configured to generate a trigger signal at the trigger output for triggering the pyro switch via energy of the reservoir capacitor, wherein the method comprising the following steps:
a) generating a reference signal at the reference input via and depending on the first reference impedance,
b) receiving a reference signal at a reference input of the IC, and
c) generating a driver signal depending on the reference signal via the IC at the driver output for charging the reservoir capacitor.
